# FASCICULE DE BREVET EUROPEEN

(11) **EP 2 760 786 B1**
(45) Date de publication et mention de la délivrance du brevet: **02.05.2018**
(21) Numéro de dépôt: 12762648.9
(22) Date de dépôt: 28.09.2012
(51) Int. Cl.: C01B 32/20, B82Y 30/00, B82Y 40/00, H01L 21/02, H01L 29/16, C01B 32/184, C01B 32/188

(54) **PROCÉDÉ DE FORMATION D'UNE COUCHE DE GRAPHÈNE À LA SURFACE D'UN SUBSTRAT COMPRENANT UNE COUCHE DE SILICIUM**
VERFAHREN ZUR HERSTELLUNG EINER GRAPHENSCHICHT AUF DER OBERFLÄCHE EINES EINE SILIZIUMSCHICHT ENTHALTENDEN SUBSTRATS
PROCESS FOR PREPARING A LAYER OF GRAPHENE ON THE SURFACE OF A SUBSTRATE COMPRISING A LAYER OF SILICON

(30) Priorité: 30.09.2011 FR 1158818
(43) Date de publication de la demande: 06.08.2014
(73) Titulaire: Centre National de la Recherche Scientifique, 75016 Paris (FR)
(72) Inventeur: OUERGHI, Abdelkarim, F-91120 Palaiseau (FR)
(74) Mandataire: Novagraaf Technologies
(86) Numéro de dépôt international: PCT/EP2012/069232
(87) Numéro de publication internationale: WO 2013/045641

(56) Documents cités:
- M. H. OLIVEIRA ET AL: "Influence of the silicon carbide surface morphology on the epitaxial graphene formation", APPLIED PHYSICS LETTERS, vol. 99, no. 11, 1 janvier 2011 (2011-01-01), page 111901, XP055026523, ISSN: 0003-6951, DOI: 10.1063/1.3638058
- OUERGHI A ET AL: "Structural coherency of epitaxial graphene on 3Câ SiC(111) epilayers on Si(111)", APPLIED PHYSICS LETTERS, AIP, AMERICAN INSTITUTE OF PHYSICS, MELVILLE, NY, US, vol. 97, no. 16, 18 octobre 2010 (2010-10-18), pages 161905-161905, XP012137335, ISSN: 0003-6951, DOI: 10.1063/1.3497287
- DIMITRAKOPOULOS CHRISTOS ET AL: "Wafer-scale epitaxial graphene growth on the Si-face of hexagonal SiC (0001) for high frequency transistors", JOURNAL OF VACUUM SCIENCE AND TECHNOLOGY: PART B, AVS / AIP, MELVILLE, NEW YORK, NY, US, vol. 28, no. 5, 7 septembre 2010 (2010-09-07), pages 985-992, XP012144266, ISSN: 1071-1023, DOI: 10.1116/1.3480961

## Description

Procédé de formation d'une couche de graphène à la surface d'un substrat comprenant une couche de silicium.

L'invention concerne un procédé de formation d'une couche de graphène à la surface d'un substrat comprenant une couche de silicium.

Dans la présente demande, on se référera au vocabulaire classique des escaliers pour lequel une marche est la face sur laquelle on pose le pied, une contremarche est la face s'étendant entre deux marches, un giron de marche est la largeur d'une marche de contremarche à contremarche, une hauteur de marche est la largeur d'une contremarche de marche à marche ...

### ARRIERE-PLAN DE L'INVENTION

Le graphite est une forme allotropique du carbone dont la structure cristalline est un empilement de plans de feuillets hexagonaux formés par des atomes de carbone, un plan de feuillets étant nommé graphène.

Pour la présente demande, on entendra par couche de graphène aussi bien un unique plan de feuillets qu'un empilement de plusieurs plans de feuillets pour lesquels chaque plan de feuillets est tourné par rapport aux autres plans de feuillets de l'empilement. En effet, dans ce dernier cas, chaque plan de feuillets est du graphène dont les propriétés sont indépendantes de celles des autres plans de feuillets ce qui est à distinguer d'un bloc de graphite dont chaque plan de feuillets a sensiblement les mêmes propriétés que les autres plans de feuillets.

Le graphène possède des propriétés électroniques exceptionnelles et pourrait apporter grandement au domaine de l'électronique. Le graphène est cependant un matériau difficile à maîtriser. Ainsi, au cours des dernières années, de nombreux projets de recherche ont été mis en place pour tenter de comprendre les propriétés électroniques du graphène et pour fabriquer un tel matériau.

Actuellement, il existe deux grands procédés de fabrication d'une couche de graphène.

Un premier procédé, dit d'exfoliation, consiste à prélever une fine lamelle d'un substrat massif de graphite à l'aide d'un ruban adhésif. L'opération est renouvelée une nouvelle fois sur la lamelle ainsi prélevée afin d'obtenir une nouvelle lamelle d'épaisseur moindre. Il est procédé de même jusqu'à d'obtention d'échantillons d'une unique couche d'atomes soit d'une couche de graphène.

Ce procédé s'avère toutefois difficilement exploitable d'un point de vue industriel.

Un deuxième procédé consiste à former une couche de graphène à la surface d'un substrat de carbure de silicium. Le substrat est chauffé progressivement jusqu'à sublimation du silicium d'au moins les premières rangées d'atomes du substrat afin de former la couche de graphène à la surface libre dudit substrat.

Ce procédé s'avère cependant très coûteux, les substrats de carbure de silicium étant d'un prix très élevé.

Depuis peu, il est apparu un troisième procédé plus perfectionné que les deux procédés précédemment cités. Ce troisième procédé consiste à former une couche de graphène à la surface d'un substrat comprenant une couche de silicium comprenant les étapes successives de :
- former un film de carbure de silicium sur une surface libre de la couche de silicium ; et
- chauffer progressivement le substrat jusqu'à sublimation du silicium d'au moins les premières rangées d'atomes du film de carbure de silicium afin de former la couche de graphène sur le film de carbure de silicium.

Former un film de carbure de silicium permet de créer une couche dite d'accrochage autorisant la formation du graphène. Le substrat utilisé réduit grandement le coût de production d'une telle couche de graphène, les substrats de silicium ou comportant une couche de silicium étant bien moins coûteux que ceux en carbure de silicium.

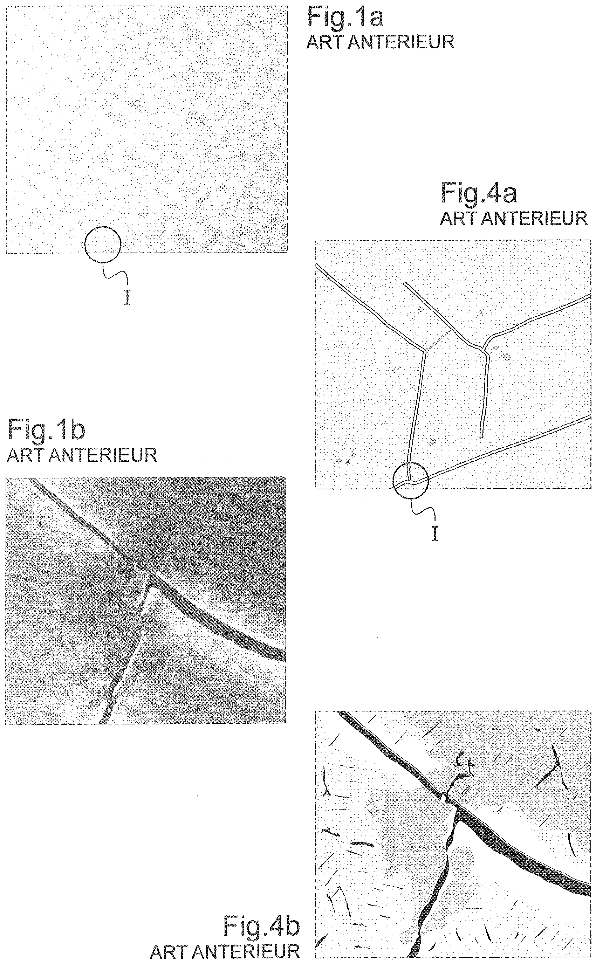

Toutefois, il a été constaté que la couche de graphène ainsi formée présentait de nombreuses fissures. Les figures la et 1b sont des photographies d'une portion d'une couche de graphène formée selon le troisième procédé précédemment expliqué, la figure 1b étant un grossissement d'une partie I de la figure la. Les figures 4a et 4b sont des vues reproduisant schématiquement les photographies illustrées respectivement à la figure la et à la figure 1b. En référence aux figures la, 1b, 4a, 4b, des fissures sont bien visibles.

Afin d'obtenir une couche de graphène de bonne qualité, la couche de graphène est alors définitivement séparée en différents morceaux prédéfinis par les fissures. Il n'est ainsi possible de former par ce procédé que des morceaux de graphène de petite taille de l'ordre de 5 à 10 micromètres de diamètre.

Il a été proposé d'améliorer le troisième procédé en chauffant le substrat sous un flux contrôlé d'argon.

L'inventeur a pu constater que cela ne suffisait pas pour éviter la formation de fissures.

Ouerghi et al, APPL. PHYS. LETT., vol. 97, 2010, pages 161905-161905, divulgue la croissance d'une couche de graphène sur un substrat du type 3C-SiC(111)/Si(111). Ce substrat a été préparé par déposition d'une couche de carbure de silicium sur un substrat de silicium. La couche de carbure de silicium est en escalier.

### OBJET DE L'INVENTION

Un but de l'invention est de proposer un procédé de formation d'une couche de graphène à la surface d'un substrat comportant une couche de silicium et un film de carbure de silicium disposé sur la couche de silicium qui permet de réaliser une couche de graphène de meilleure qualité qu'avec les procédés de l'art antérieur.

### BREVE DESCRIPTION DE L'INVENTION

A cet effet, on propose un procédé de formation d'une couche de graphène à la surface d'un substrat comprenant une couche de silicium, le procédé comportant les étapes successives de :
- former un film de carbure de silicium sur une surface libre de la couche de silicium ;
- chauffer progressivement le substrat jusqu'à sublimation du silicium d'au moins les premières rangées d'atomes du film de carbure de silicium afin de former la couche de graphène sur le film de carbure de silicium.

Selon l'invention, on utilise une couche de silicium dont la surface libre est en escalier.

De façon remarquable, l'étagement de la couche de silicium permet de former un film de carbure de silicium de bien meilleure qualité cristalline et électronique.

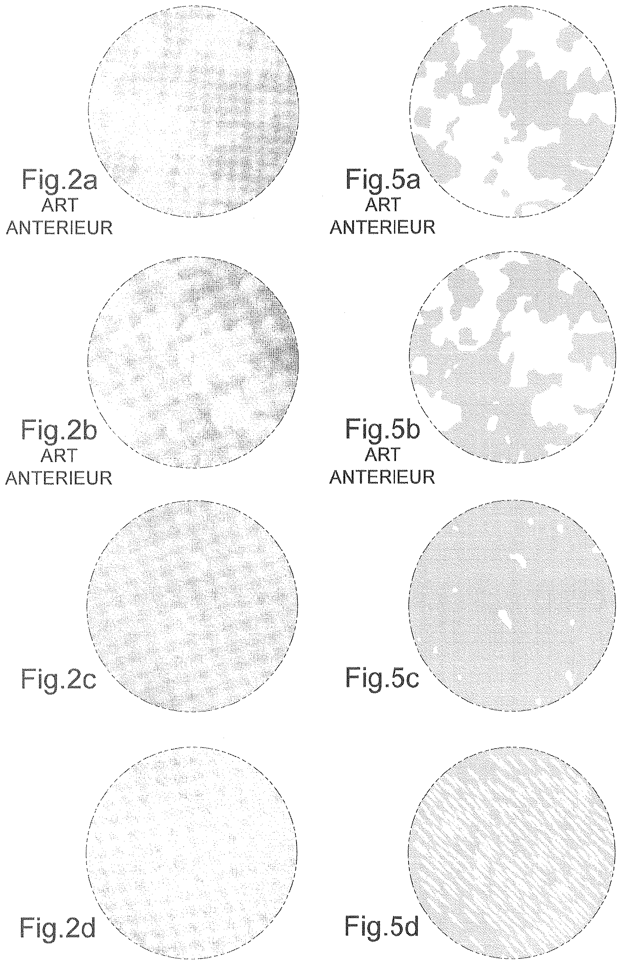

Les figures 2a, 2b sont des photographies d'une portion du film de carbure de silicium produit par le troisième procédé de l'art antérieur selon une première direction cristalline (figure 2a) et une deuxième direction cristalline (figure 2b). Les figures 5a et 5b sont des vues reproduisant schématiquement les photographies illustrées respectivement à la figure 2a et à la figure 2b. Les figures 2c, 2d sont des photographies d'une portion du film de carbure de silicium produit par le procédé selon l'invention selon la première direction cristalline (figure 2c) et la deuxième direction cristalline (figure 2d). Les figures 5c et 5d sont des vues reproduisant schématiquement les photographies illustrées respectivement à la figure 2c et à la figure 2d. En référence aux figures 2a à 2d et 5a à 5d, il est ainsi visible que le film de carbure de silicium obtenu par le procédé de l'invention présente une structure cristalline bien plus homogène que le film de carbure de silicium de l'art antérieur.

Or l'inventeur a pu constater que le graphène formé à partir d'un film de carbure de silicium était particulièrement sensible à la qualité du film de carbure de silicium et en particulier à la qualité de la surface libre du film de carbure de silicium. Ainsi, l'étagement de la couche de silicium permet de former un film de carbure de silicium de bien meilleure qualité ce qui permet ainsi d'obtenir un graphène de bien meilleure qualité.

De façon plus précise, l'inventeur a constaté que les fissures dans la couche de graphène formée par un procédé de l'art antérieur étaient dues au moins en partie au substrat. En effet, lorsque l'on chauffe le substrat jusqu'à sublimation du silicium du film de carbure de silicium, il s'avère que des atomes de silicium du substrat ont également tendance à sublimer à la surface du film de carbure de silicium en se diffusant dans le substrat et le film de carbure de silicium à travers les défauts cristallins (comme des défauts d'antiphases) dudit substrat et dudit film. On rappelle que dans une structure cristalline, un site est occupé par un élément donné. Lorsque ledit site est occupé par un atome d'un autre élément il y a un défaut dit d'antiphase.

Cette sublimation forcée d'atomes de silicium du substrat entraîne, à cause de contraintes mécaniques existantes intrinsèquement dans le film de carbure de silicium, et notamment à la frontière entre le film et le substrat, des fissures dans le graphène ainsi formé lors du refroidissement du substrat.

Ainsi, moins le film de carbure de silicium présente de défauts, moins le nombre d'atomes de silicium du substrat se diffusant dans le film de carbure de silicium est important. Il est ainsi possible de limiter l'apparition de fissure en contrôlant la qualité cristalline du film de carbure de silicium.

Selon l'invention, l'étagement de la couche de silicium permet de former un film de carbure de silicium de bien meilleure qualité. Par exemple, le film de carbure de silicium comporte bien moins de défauts d'antiphases voire pas du tout de défauts. Ainsi, on évite l'apparition des fissures dans la couche de graphène ce qui permet d'obtenir un graphène de bien meilleure qualité.

A titre d'exemple, l'inventeur a ainsi pu obtenir des couches de graphène de plusieurs centimètres carrés. Le procédé permet de rendre une technologie d'électronique rapide à base de carbone plus intéressante industriellement parlant. Le graphène peut donc être une plateforme idéale pour des composants électroniques à base de carbone.

De façon avantageuse, le procédé permet de former des morceaux d'une couche de graphène de grandes dimensions et ce quelle que soit la structure cristalline de la couche de silicium ou du film de carbure de silicium, ou quelle que soit une direction de la structure cristalline de la couche de silicium par rapport à laquelle est orientée la surface libre de la couche de silicium.

### BREVE DESCRIPTION DES DESSINS

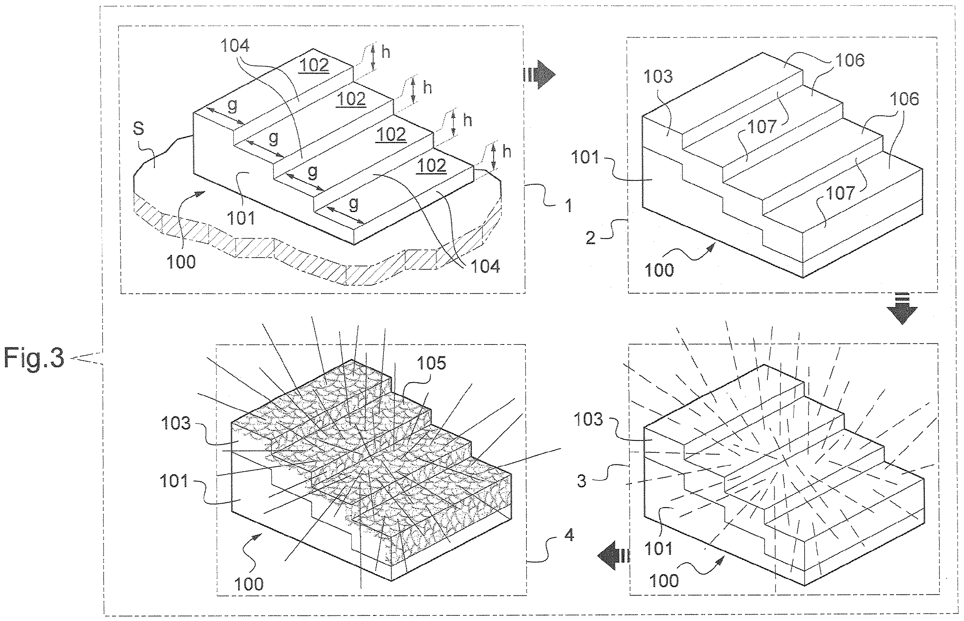

L'invention sera mieux comprise à la lumière de la description qui suit d'une mise en oeuvre particulière non limitative de l'invention en référence aux figures ci-jointes parmi lesquelles, outre les figures 1a, 1b, 4a, 4b, 2a, 2b, 2c, 2d, 5a, 5b, 5c et 5d déjà décrites, la figure 3 illustre schématiquement les différentes étapes du procédé selon l'invention.

### DESCRIPTION DETAILLEE DE L'INVENTION

En référence à la figure 3, une première étape 1 du procédé de l'invention consiste à utiliser un substrat 100 comprenant une couche de silicium 101. Selon l'invention, on utilise une couche de silicium 101 dont la surface libre est en escalier et comporte des marches 102 séparées par des contremarches 104.

Dans une deuxième étape 2, on forme un film de carbure de silicium 103 sur une surface libre de la couche de silicium 101 (le film de carbure de silicium étant représenté exagérément épais à la figure 3 pour faciliter la compréhension de la figure 3) . Le fait que la couche de silicium 101 soit étagée ne modifie pas les procédés usuels de formation d'un film de carbure de silicium à la surface d'une couche de silicium. Il est par exemple connu de former un tel film de carbure de silicium par dépôt chimique en phase vapeur (ou Chemical Vapor Déposition en anglais), par épitaxie par jet moléculaire (ou Molecular Beam Epitaxy en anglais), par épitaxie en phase vapeur (Vapor Phase Epitaxy en anglais) ...

De part l'étagement de la surface libre de la couche de silicium 101, le film de carbure de silicium 103 ainsi formé est également en escalier et comporte des marches 106 séparées par des contremarches 107.

De façon remarquable, la qualité du film de carbure de silicium 103 est ainsi augmentée en comparaison avec la qualité d'un film de carbure de silicium formé sur un substrat non étagé.

Dans une troisième étape 3, on préchauffe le substrat 100 sous un flux contrôlé de silicium gazeux (symbolisé par des pointillés). Ainsi, le film de carbure de silicium 103 est saturé à sa surface libre d'atomes de silicium ce qui retarde une sublimation du silicium du carbure de silicium dû au chauffage du substrat 100 comme détaillé à la quatrième étape 4.

Grâce à cette troisième étape 3, il est possible de contrôler le moment où les atomes de silicium du film de carbure de silicium 103 commencent à sublimer ce qui permet de mieux contrôler ladite sublimation et d'obtenir au final une couche de graphène de meilleure qualité.

Dans la quatrième étape 4, on chauffe le substrat 100 en augmentant progressivement la température de chauffage jusqu'à sublimation du silicium d'au moins les premières rangées d'atomes du film de carbure de silicium 103.

A condition de chauffer progressivement le substrat 100, il se créé alors à la surface du film de carbure de silicium 103 des zones plus concentrées en atomes de carbone qui vont naturellement s'agencer selon une structure cristalline qui est celle du graphène. Il se forme ainsi une couche de graphène 105 sur le film de carbure de silicium 103 par recuit thermique d'au moins une partie du film de carbure de silicium 103.

Selon un mode de réalisation privilégié, les contremarches 104 de la couche de silicium 101 ont des hauteurs h sensiblement identiques tandis que les marches 102 de la couche de silicium 101 ont des girons g sensiblement identiques.

De façon avantageuse, la surface libre de la couche de silicium facilite alors encore davantage la formation d'un film de carbure de silicium 103 de meilleure qualité et donc d'une couche de graphène 105 de meilleure qualité.

Selon un mode de réalisation privilégié, chaque contremarche 104 de la couche de silicium 101 s'étend sensiblement perpendiculairement aux deux marches 102 de la couche de silicium 101 adjacentes.

De préférence, chaque marche 102 de la couche de silicium 101 s'étend sensiblement à plat c'est-à-dire sensiblement parallèlement à un support S sur lequel le substrat 100 repose.

De façon avantageuse, la surface libre de la couche de silicium 101 facilite alors encore davantage la formation d'une couche de graphène de meilleure qualité.

De façon privilégiée, lors de cette quatrième étape 4, le substrat 100 est chauffé sous un flux contrôlé de gaz inerte. De préférence, le gaz inerte est de l'azote (symbolisé par des traits plein).

Il s'avère que le chauffage sous un flux contrôlé d'azote permet de mieux contrôler la sublimation des atomes de silicium et d'obtenir au final une couche de graphène de meilleure qualité.

Un exemple particulier de mise en oeuvre du procédé de l'invention va être à présent décrit. Cet exemple n'est bien sûr pas limitatif.

Au cours de la première étape 1, on utilise une couche de silicium 101 qui a une structure cristalline de type cubique et dont la surface libre est en escalier qui présente des marches 102 et des contremarches 104 sensiblement identiques, chaque contremarche 104 s'étendant sensiblement perpendiculairement aux deux marches 102 adjacentes. En outre, chaque marche 102 s'étend sensiblement à plat. Les contremarches 104 ont une hauteur h comprise entre 2 et 3 Angström et les marches 102 ont un giron compris entre 35 et 40 Angström.

Au cours de la deuxième étape 2, on forme le film de carbure de silicium 103 sur la couche de silicium 101. De façon privilégiée, on forme le film de carbure de silicium 103 de façon à ce qu'il ait une structure cristalline de type 3C.

Lors d'une étape intermédiaire, le substrat 100 est chauffé à 600 degrés Celsius sous des conditions d'ultra-haut vide (Ultra High Vacuum en anglais) pendant plusieurs heures. De façon connue, cette étape permet de dégazer la couche en enlevant les molécules d'eau ou les molécules adsorbées du film de carbure de silicium de sorte à améliorer la qualité dudit film.

Lors de la troisième étape 3, on préchauffe le substrat 101, en portant la température de chauffage à 700 degrés Celsius, sous un flux contrôlé de silicium gazeux à 10 à 15 monocouches par minute.

Puis, au cours de la quatrième étape 4, on chauffe progressivement le substrat 100 en augmentant la température de chauffage de 700 degrés Celsius jusqu'à 1300 degrés Celsius sous un flux contrôlé d'azote à une pression de 10⁻⁵ millimètres de mercure afin d'obtenir la couche de graphène 105.

L'invention n'est pas limitée à ce qui vient d'être décrit, mais bien au contraire englobe toute variante entrant dans le cadre défini par les revendications.

En particulier, le procédé selon l'invention pourra ne pas comporter la troisième étape 3 au cours de laquelle on préchauffe le substrat 100 sous un flux contrôlé de silicium gazeux. Au cours de la troisième étape 3, on pourra préchauffer le substrat sous un flux contrôlé de gaz inerte, par exemple l'azote, et non sous un flux contrôlé de silicium gazeux. Selon une variante, au cours de la troisième étape 3, on pourra préchauffer le substrat sous à la fois un flux contrôlé de silicium gazeux et à la fois sous un flux contrôlé de gaz inerte.

Lors de la quatrième étape 4, on pourra ne pas diffuser un flux contrôlé de gaz inerte sur le substrat 100 lors de son chauffage. On pourra chauffer le substrat 100 sous un flux contrôlé d'un autre gaz inerte que l'azote comme par exemple de l'argon.

Comme cela a déjà été dit dans l'exemple décrit, le procédé selon l'invention pourra comporter différentes étapes intermédiaires entre la deuxième étape 2 de formation du film de carbure de silicium et la quatrième étape 4 de formation de la couche de graphène 105 afin de réaliser différents traitements du film de carbure de silicium 103. Encore une fois, le graphène formé à partir d'un film de carbure de silicium est particulièrement sensible à la qualité de la surface du film de carbure de silicium. Plus le film de carbure de silicium 103 aura une qualité cristalline importante, plus la couche de graphène 105 obtenue sera de bonne qualité en possédant notamment un nombre restreint voir nul de fissures et moins de défauts cristallins. On pourra par exemple réaliser un traitement chimique du film de carbure de silicium 103 comme un « wet etching » (gravure mouillée de la surface libre) ou bien un recuit sous hydrogène.

L'exemple décrit n'est pas limitatif. On pourra ainsi jouer sur les dimensions de la surface libre en escalier de la couche de silicium 101 ou sur sa structure cristalline pour contrôler des caractéristiques de la couche de graphène 105 que l'on souhaite former. On pourra également jouer sur la température de chauffage du substrat 100 et la pression sous laquelle on effectue le chauffage pour contrôler la formation de la couche de graphène 105.

Par exemple, on pourra chauffer le substrat à une autre température lors de la troisième étape 3 et la quatrième étape 4. De préférence, lors de cette quatrième étape 4, on chauffera le substrat 100 jusqu'à une température comprise entre 1200 degrés Celsius et 1400 degrés Celsius. On pourra également lors de cette quatrième étape chauffer le substrat 100 sous une autre pression que 10⁻⁵ millimètres de mercure. A cet effet, la pression pourra être choisie entre une pression de l'ordre de la pression atmosphérique et une pression de l'ordre de 10⁻⁷ millimètres de mercure.

## Revendications

1. Procédé de formation d'une couche de graphène (105) à la surface d'un substrat (100) comprenant une couche de silicium (101), le procédé comportant les étapes successives de :
- former un film de carbure de silicium (103) sur une surface libre de la couche de silicium ;
- chauffer progressivement le substrat jusqu'à sublimation du silicium d'au moins les premières rangées d'atomes du film de carbure de silicium afin de former la couche de graphène sur le film de carbure de silicium ;
le procédé étant **caractérisé en ce qu'**on utilise une couche de silicium dont la surface libre est en escalier.

2. Procédé selon la revendication 1, dans lequel la surface en escalier comporte des marches (102) séparées par des contremarches (104) qui ont des hauteurs (h) identiques tandis que les marches ont des girons (g) identiques.

3. Procédé selon la revendication 1, dans lequel la surface libre en escalier comporte des marches (102) séparées par des contremarches (104) qui s'étendent perpendiculairement à deux marches adjacentes.

4. Procédé selon la revendication 1, dans lequel la surface libre en escalier comporte des marches (102) séparées par des contremarches (104), chaque marche s'étendant parallèlement à un support (S) sur lequel le substrat repose.

5. Procédé selon la revendication 1, dans lequel la surface libre en escalier comporte des marches (102) séparées par des contremarches (104) qui ont une hauteur (h) comprise entre 2 et 3 Angström tandis que les marches (102) ont un giron (g) compris entre 35 et 40 Angström.

6. Procédé selon la revendication 1, dans lequel on chauffe le substrat (100) sous un flux contrôlé de gaz inerte.

7. Procédé selon la revendication 6, dans lequel le gaz inerte est de l'azote.

8. Procédé selon la revendication 1, comportant l'étape préalable de préchauffer le substrat (100) sous un flux contrôlé de silicium gazeux avant l'étape de le chauffage du substrat jusqu'à sublimation d'au moins les premières rangées d'atomes du film de carbure de silicium (103) .

## Patentansprüche

1. Verfahren zur Bildung einer Graphenschicht (105) auf der Oberfläche eines Substrats (100), umfassend eine Siliziumschicht (101), wobei das Verfahren aus den folgenden sukzessiven Schritte besteht:
- Bilden eines Siliziumcarbidfilms (103) auf einer freien Oberfläche der Siliziumschicht;
- zunehmendes Erhitzen des Substrats bis zur Sublimation des Siliziums von mindestens den ersten Atomreihen des Siliziumkarbidfilms, um die Graphenschicht auf dem Siliziumkarbidfilm zu bilden;
wobei das Verfahren **dadurch gekennzeichnet ist, dass** eine Siliziumschicht verwendet wird, deren freie Oberfläche treppenförmig ist.

2. Verfahren nach Anspruch 1, wobei die treppenförmige Oberfläche aus Stufen (102) besteht, die durch Gegenstufen (104) getrennt sind, die identische Höhen (h) aufweisen, während die Stufen identische Auftritte (g) aufweisen.

3. Verfahren nach Anspruch 1, wobei die freie treppenförmige Oberfläche aus Stufen (102) besteht, die durch Gegenstufen (104) getrennt sind, die sich senkrecht zu zwei benachbarten Stufen erstrecken.

4. Verfahren nach Anspruch 1, wobei die freie treppenförmige Oberfläche aus Stufen (102) besteht, die durch Gegenstufen (104) getrennt sind, wobei sich jede Stufe parallel zu einem Träger (S) erstreckt, auf dem das Substrat aufliegt.

5. Verfahren nach Anspruch 1, wobei die freie treppenförmige Oberfläche aus Stufen (102) besteht, die durch Gegenstufen (104) getrennt sind, die eine Höhe (h) aufweisen, die im Bereich zwischen 2 und 3 Angström liegt, während die Stufen (102) einen Auftritt (g) aufweisen, der im Bereich zwischen 35 und 40 Angström liegt.

6. Verfahren nach Anspruch 1, wobei das Substrat (100) unter einem gesteuerten Fluss von inertem Gas erhitzt wird.

7. Verfahren nach Anspruch 6, wobei das inerte Gas Stickstoff ist.

8. Verfahren nach Anspruch 1, bestehend aus einem vorherigen Schritt des Vorerhitzens des Substrats (100) unter einem gesteuerten Fluss von gasförmigem Silizium vor dem Schritt des Erhitzens des Substrats bis zur Sublimation von mindestens den ersten Atomreihen des Siliziumkarbidfilms (103).

## Claims

1. A process for forming a graphene layer (105) on the surface of a substrate (100) comprising a silicon layer (101), the process comprising, in succession, steps of:
- forming a silicon carbide film (103) on a free surface of the silicon layer; and
- gradually heating the substrate until sublimation of the silicon in at least the first lattice-arrays of atoms of the silicon carbide film, in order to form the graphene layer on the silicon carbide film,
the process being **characterized in that** a silicon layer having a stepped free surface is used.

2. The process as claimed in claim 1, in which the stepped surface comprises treads (102) separated by risers (104) that have substantially identical rises (h), whereas the treads have substantially identical runs (g).

3. The process as claimed in claim 1, in which the stepped free surface comprises treads (102) separated by risers (104) that extend substantially perpendicularly to two adjacent treads.

4. The process as claimed in claim 1, in which the stepped free surface comprises treads (102) separated by risers (104), each tread extending substantially parallel to a holder (S) on which the substrate rests.

5. The process as claimed in claim 1, in which the stepped free surface comprises treads (102) separated by risers (104) that have a rise (h) comprised between 2 and 3 Angströms, whereas the treads (102) have a run (g) comprised between 35 and 40 Angströms.

6. The process as claimed in claim 1, in which the substrate (100) is heated under a controlled flow of inert gas.

7. The process as claimed in claim 6, in which the inert gas is nitrogen.

8. The process as claimed in claim 1, comprising the prior step of preheating the substrate (100) under a controlled flow of gaseous silicon, before the substrate is heated until sublimation of at least the first lattice-arrays of atoms in the silicon carbide film (103).
